# EUROPEAN PATENT APPLICATION

(11) **EP 3 051 811 A1**
(43) Date of publication of application: **03.08.2016**
(21) Application number: 14848227.6
(22) Date of filing: 24.09.2014
(51) Int. Cl.: H04N 9/07, H01L 27/146, H04N 5/347, H04N 5/3745

(54) **IMAGE PICKUP ELEMENT AND IMAGE PICKUP DEVICE**

(30) Priority: 26.09.2013 JP 2013199712
(71) Applicant: Nikon Corporation, Tokyo 108-6290 (JP)
(72) Inventor: MURATA, Hironobu, Tokyo 100-8331 (JP)
(74) Representative: Hoffmann Eitle
(86) International application number: PCT/JP2014/004885
(87) International publication number: WO 2015/045375

(57) **Abstract**

To provide an imaging element comprising: two first pixels that are arranged serially in a first direction and detect light of a first color; two second pixels that are arranged serially in a second direction intersecting the first direction, are adjacent to the two first pixels, and detect light of a second color; a plurality of first light-receiving regions that are arranged in the first pixels, receive light of the first color, and are divided in the first direction; and a plurality of second light-receiving regions that are arranged in the second pixels, receive light of the second color, and are divided in the second direction.

## Description

### BACKGROUND

### 1. TECHNICAL FIELD

The present invention relates to an imaging element and an imaging device.

### 2. RELATED ART

An imaging device that performs focus detection by a pupil-dividing phase difference scheme based on output signals from a plurality of pixels dedicated to focus detection arranged at a part of an imaging element has been known (for example, Patent Document 1).

Patent Document 1: Japanese Patent Application Publication No. 2011-77770

Conventionally, because pixels for focus detection are arranged by being scattered, the precision of focus detection becomes lower as compared with a case where pixels for focus detection are arranged serially. On the other hand, when pixels for focus detection corresponding to a color filter of a particular color are arranged serially, the pixel array becomes different from a predetermined array such as a Bayer array. In conventional techniques, operations become complicated when the array is to be converted into a predetermined array such as a Bayer array by interpolation or the like.

### SUMMARY

A first aspect of the present invention provides an imaging element comprising: two first pixels that are arranged serially in a first direction and detect light of a first color; two second pixels that are arranged serially in a second direction intersecting the first direction, are adjacent to the two first pixels, and detect light of a second color; a plurality of first light-receiving regions that are arranged in the first pixels, receive light of the first color, and are divided in the first direction; and a plurality of second light-receiving regions that are arranged in the second pixels, receive light of the second color, and are divided in the second direction.

A second aspect of the present invention provides an imaging element comprising: a plurality of first pixels that are arrayed along a first direction and a second direction, and correspond to a first color; and a plurality of other pixels that are provided in respective regions surrounded by four contiguous first pixels, and correspond to a color different from the first color, wherein among the plurality of first pixels and the plurality of other pixels, at least some pixels have two separate light-receiving regions.

A third aspect of the present invention provides an imaging device comprising the imaging element according to the first or second aspect.

The summary clause does not necessarily describe all necessary features of the embodiments of the present invention. The present invention may also be a sub-combination of the features described above.

### BRIEF DESCRIPTION OF THE DRAWINGS

FIG. 1 is a figure illustrating the gist of an imaging element 100 according to one embodiment.
FIG. 2A is a figure illustrating one example of first pixels 202-1.
FIG. 2B is a figure illustrating one example of second pixels 202-2 and third pixels 202-3.
FIG. 3 is a figure illustrating one example of a light-receiving unit 200.
FIG. 4 is a figure illustrating one example of an array conversion process in a signal processing unit 210
FIG. 5 is a figure illustrating an array example of first conversion pixels 203-1.
FIG. 6 is a figure illustrating one example of an array conversion process in the signal processing unit 210.
FIG. 7 is a figure illustrating an array example of second conversion pixels 203-2 and third conversion pixels 203-3.
FIG. 8 is a figure illustrating an array example of the first conversion pixels 203-1, the second conversion pixels 203-2 and the third conversion pixels 203-3.
FIG. 9 is a figure illustrating another example of the light-receiving unit 200.
FIG. 10A is a figure illustrating an example of generating a first conversion pixel signal G1.
FIG. 10B is a figure illustrating an example of generating a second conversion pixel signal G2.
FIG. 10C is a figure illustrating an example of generating a third conversion pixel signal G3.
FIG. 10D is a figure illustrating an example of generating a fourth conversion pixel signal G4.
FIG 11A is a perspective view of a microlens 101.
FIG. 11 B is a figure illustrating the planar shape of the microlens 101.
FIG. 12 is a figure illustrating another processing example of the signal processing unit 210.
FIG. 13 is a figure illustrating a configuration example of the light-receiving unit 200.
FIG. 14 is a figure illustrating another configuration example of the light-receiving unit 200.
FIG. 15 is a figure illustrating arrangement examples of a transfer transistor TX and of an electrical charge detecting unit in the example illustrated in FIG. 14.
FIG. 16 is a figure illustrating one example of a cross-section of the imaging element 100.
FIG. 17 is a block diagram illustrating some of functions of the signal processing unit 210.
FIG 18 is a figure for explaining a relationship between lens characteristics and output signals.
FIG. 19 is a block diagram illustrating a configuration example of an imaging device 500 according to one embodiment.

### DESCRIPTION OF EXEMPLARY EMBODIMENTS

Hereinafter, (some) embodiment(s) of the present invention will be described. The embodiment(s) do(es) not limit the invention according to the claims, and all the combinations of the features described in the embodiment(s) are not necessarily essential to means provided by aspects of the invention.

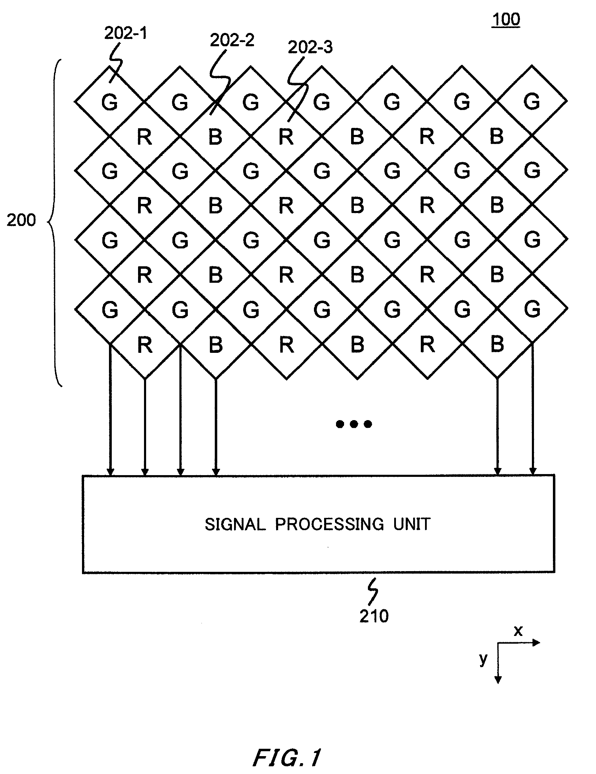

FIG. 1 is a figure illustrating the gist of an imaging element 100 according to one embodiment. The imaging element 100 comprises a light-receiving unit 200 in which a plurality of pixels 202 are arrayed, and a signal processing unit 210 that processes a signal from the light-receiving unit 200. The plurality of pixels 202 respectively have photodetectors such as photodiodes, and accumulate electrical charges according to light-receiving amounts. The signal processing unit 210 in the present example reads out a signal according to an amount of electrical charges accumulated in each pixel 202, and performs a predetermined process.

The plurality of pixels 202 in the present example are arrayed in a matrix form. That is, the plurality of pixels 202 are arranged along a plurality of rows and a plurality of columns. In the present specification, the row direction is illustrated as the x-axis direction, and the column direction is illustrated as the y-axis direction. The row direction is one example of a first direction, and the column direction is one example of a second direction.

The plurality of pixels 202 include a plurality of first pixels 202-1, a plurality of second pixels 202-2 and a plurality of third pixels 202-3. The first pixel 202-1 is a pixel corresponding to a color filter of a first color, the second pixel 202-2 is a pixel corresponding to a color filter of a second color, and the third pixel 202-3 is a pixel corresponding to a color filter of a third color. In the present example, the first color is green, the second color is blue, and the third color is red. In the present example, the planar shape of the respective pixels 202 is quadrangle, and each side of the pixels 202 is inclined by 45 degrees relative to the first direction and the second direction. In a more specific example, the planar shape of the respective pixels 202 is square.

The plurality of first pixels 202-1 are arrayed along both the row direction and the column direction. In the present example, the plurality of first pixels 202-1 are arranged such that each vertex of the first pixels 202-1 is adjacent to another vertex. With such arrangement, a region surrounded by four first pixels 202-1 arranged contiguously is formed. The second pixels 202-2 and the third pixels 202-3 are provided in regions surrounded by four first pixels 202-1. In the present example, the shapes of the respective pixels 202 are the same.

The second pixels 202-2 are arrayed along the column direction. Also, the third pixels 202-3 are arrayed along the column direction. The columns of the second pixels 202-2 and the columns of the third pixels 202-3 are arranged alternately in the row direction. Also, the columns of the second pixels 202-2 and the columns of the third pixels 202-3 are arrayed by being shifted by a half-pixel in the column direction relative to the columns of the first pixel 202-1.

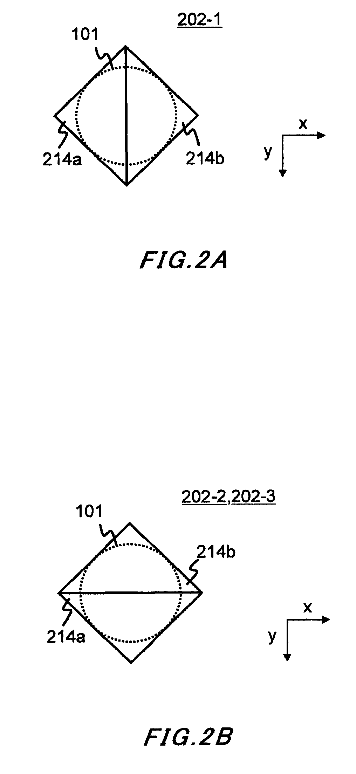

FIG 2A is a figure illustrating one example of the first pixels 202-1. At least some of the first pixels 202-1 have two separate light-receiving regions 214. A first light-receiving region 214a and a second light-receiving region 214b in the first pixel 202-1 are arrayed side by side in the row direction. In the present example, the two light-receiving regions 214 are defined by halving the region of the first pixel 202-1 with a straight line extending in the column direction. In the present example, the straight line is a diagonal of the first pixels 202-1. An element separating portion is provided between the light-receiving regions 214 so that electrical charges generated according to incident light do not move between the light-receiving regions 214. It should be noted that in FIG. 2A, a microlens 101 provided corresponding to the first pixel 202-1 is illustrated with a dotted line. The two light-receiving regions 214 in the present example are provided at different positions in the row direction relative to the common microlens 101.

In the light-receiving unit 200, the plurality of first pixels 202-1 having the two light-receiving regions 214 are arrayed adjacently in the row direction. The signal processing unit 210 functions as a focus detecting unit that detects a focused state by detecting an image surface phase difference in the row direction between signals from the first light-receiving regions 214a and second light-receiving regions 214b of the first pixels 202-1 arrayed adjacently in the row direction. Because the first pixels 202-1 for image surface phase difference detection are arrayed adjacently in the row direction, an image surface phase difference in the row direction can be detected precisely. Also, the efficiency of utilizing light can be improved as compared with a scheme in which an image surface phase difference is detected by using light-shielding.

FIG. 2B is a figure illustrating one example of the second pixels 202-2 and the third pixels 202-3. At least some of the second pixels 202-2 and the third pixels 202-3 have two separate light-receiving regions 214. The first light-receiving region 214a and the second light-receiving region 214b of the second pixel 202-2 and the third pixel 202-3 are arrayed side by side in the column direction. In the present example, the two light-receiving regions 214 are defined by halving the region of the second pixel 202-2 or the third pixel 202-3 with a straight line extending in the row direction. The two light-receiving regions 214 of the second pixel 202-2 and the third pixel 202-3 are provided at different positions in the column direction relative to the common microlens 101.

In the light-receiving unit 200, a plurality of the second pixel 202-2 or third pixel 202-3 having the two light-receiving regions 214 are arrayed adjacently in the column direction. The signal processing unit 210 functions as a focus detecting unit that detects a focused state by detecting an image surface phase difference in the column direction between signals from the first light-receiving regions 214a and second light-receiving regions 214b of the second pixels 202-2 or third pixels 202-3 arrayed adjacently in the column direction. Because the second pixels 202-2 or the third pixels 202-3 for image surface phase difference detection are arrayed adjacently in the column direction, an image surface phase difference in the column direction can be detected precisely. Also, the efficiency of utilizing light can be improved as compared with a scheme in which an image surface phase difference is detected by using light-shielding.

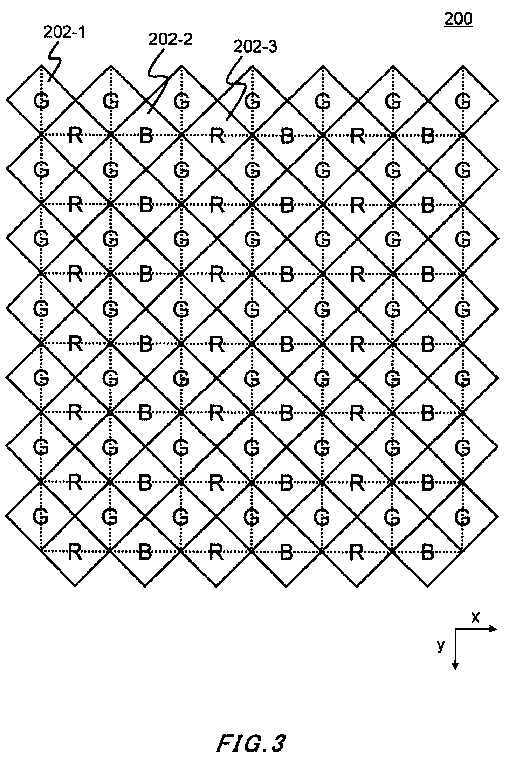

FIG 3 is a figure illustrating one example of the light-receiving unit 200. In the light-receiving unit 200 of the present example, all the pixels 202 have the two light-receiving regions 214. In FIG. 3, the boundaries of the light-receiving regions 214 in the respective pixels 202 are indicated with dotted lines. In the present example, image data is generated by using outputs of all the pixels 202, and outputs of at least some pixels 202 are used for image surface phase difference detection. The signal processing unit 210 can use a pixel 202 at any position as a pixel 202 for image surface phase difference detection.

The signal processing unit 210 may alter a pixel 202 used for image surface phase difference detection at any time. For example, the signal processing unit 210 may use a pixel 202 that is capturing an image of a particular subject as a pixel 202 for image surface phase difference detection. When the position of the pixel 202 that is capturing an image of the subject changes over time, the signal processing unit 210 may select a pixel 202 for image surface phase difference detection by following the changes. Also, all the pixels 202 may be used as pixels for image surface phase difference detection as well while using them as pixels for image signal generation. Because in the present example, light-shielding is not used for image surface phase difference detection, the efficiency of utilizing incident light does not lower even if a structure in which all the pixels 202 are used as pixels for image surface phase difference detection is employed.

Also, the signal processing unit 210 functions as an array converting unit that converts image data based on each pixel signal from the light-receiving unit 200 into image data with a predetermined pixel array such as a Bayer array. When performing array conversion, the signal processing unit 210 adds signals from the two light-receiving regions 214 of the respective pixels 202 to obtain pixel signals from the respective pixels 202.

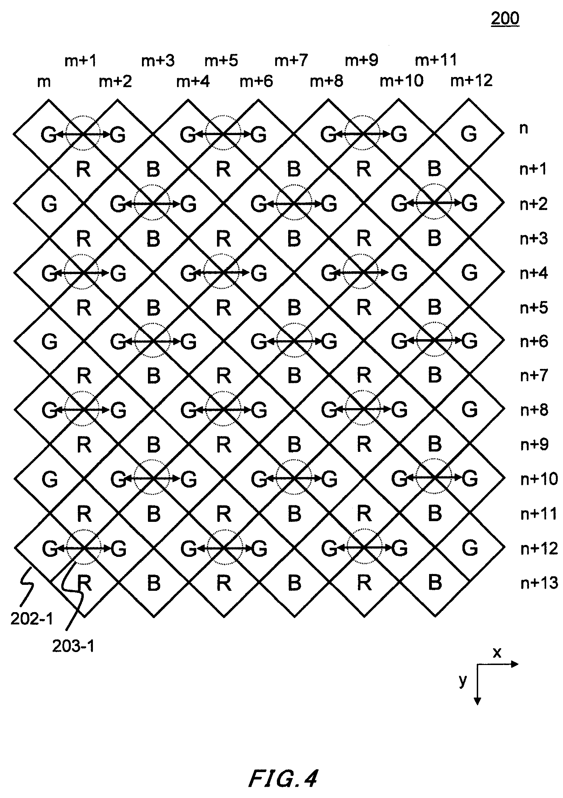

FIG. 4 is a figure illustrating one example of an array conversion process in the signal processing unit 210. In FIG. 4, the numbers of respective columns of the plurality of pixels 202 are m, m+1, m+2, ..., m+k, ..., and the numbers of respective rows of the plurality of pixels 202 are n, n+1, n+2, ..., n+1, .... Here, k and 1 are integers. In FIG. 4, a process of generating a conversion pixel signal of a first conversion pixel 203-1 after array conversion from a pixel signal of the first pixel 202-1 is explained. The first pixels 202-1 of the present example are arrayed in the columns where k is 0 or even numbers, and in the rows where 1 is 0 or even numbers.

It should be noted that the plurality of first pixels 202-1 include three or more first pixels 202-1 arranged serially in the first direction. For example, three first pixels 202-1 are arranged at the positions (m, n+2), (m+2, n+2), and (m+4, n+2). Also, the plurality of the second pixels 202-2 (corresponding to pixels B in FIG. 4) are arranged serially in the second direction intersecting the first direction, and include two second pixels 202-2 respectively adjacent to two first pixels 202-1 among the above-mentioned three first pixels 202-1. For example, second pixels 202-2 arranged at the positions (m+3, n+1) and (m+3, n+3) are respectively arranged to intersect and be adjacent to two first pixels 202-1 arranged at the positions (m+2, n+2) and (m+4, n+2).

Also, the plurality of third pixels 202-3 include two third pixels 202-3 arranged serially in the third direction intersecting the first direction, and respectively adjacent to two first pixels 202-1 among the above-mentioned three first pixels 202-1. It should be noted that the second direction and the third direction are parallel directions, and refer to directions at different locations. For example, the second direction is a direction from the position (m+3, n+1) to the position (m+3, n+3), and the third direction is a direction from the position (m+1, n+1) to the position (m+1, n+3). Also, at least one first pixel 202-1 of two first pixels 202-1 to which the two third pixels 202-3 are adjacent is different from two first pixels 202-1 to which the above-mentioned two second pixels 202-2 are adjacent. For example, the two third pixels 202-3 arranged at the positions (m+1, n+1) and (m+1, n+3) are respectively arranged to intersect and be adjacent to the two first pixels 202-1 arranged at the positions (m, n+2) and (m+2, n+2).

The signal processing unit 210 adds pixel signals of two first pixels 202-1 adjacent in the row direction to generate a conversion pixel signal of a first conversion pixel 203-1 virtually arranged between the two first pixels 202-1. In FIG. 4, two first pixels 202-1 whose pixel signals are added are connected with two-way arrows.

More specifically, the signal processing unit 210 groups the first pixels 202-1 of each row into pairs of two respectively adjacent first pixels 202-1. The signal processing unit 210 adds pixel signals of two paired first pixels 202-1 to generate a conversion pixel signal of a first conversion pixel 203-1. At this time, the first pixels 202-1 of each row are grouped such that the positions of the first conversion pixels 203-1 in the row direction are different alternately for each row of the first pixels 202-1. For example, in the (n+s)-th (s is 0, 4, 8, ....) row, first pixels 202-1 at the column positions (m, m+2), (m+4, m+6) and (m+8, m+10) are grouped together. In contrast, in the (n+s+2)-th row, first pixels 202-1 at the column positions (m+2, m+4), (m+6, m+8) and (m+10, m+12) are grouped together.

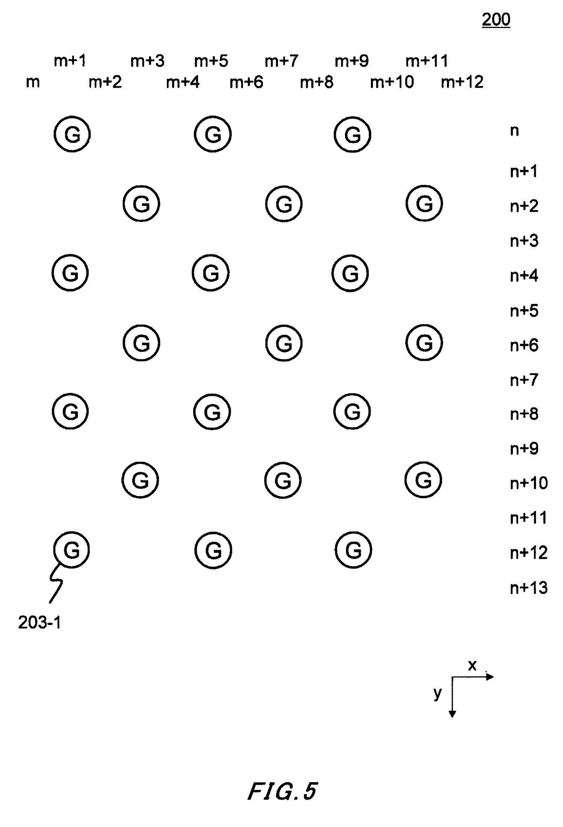

FIG 5 is a figure illustrating an array example of the first conversion pixels 203-1. By the conversion process explained with reference to FIG. 4, the first conversion pixels 203-1 are arrayed as shown in FIG. 5. That is, the first conversion pixels 203-1 are arrayed such that the positions of the first conversion pixels 203-1 in the row direction are different alternately for each row of the first conversion pixels 203-1. Specifically, in the (n+s)-th row, the first conversion pixels 203-1 are arranged at the column positions m+1, m+5 and m+9. Also, in the (n+s+2)-th row, the first conversion pixels 203-1 are arranged at the column positions m+3, m+7 and m+11.

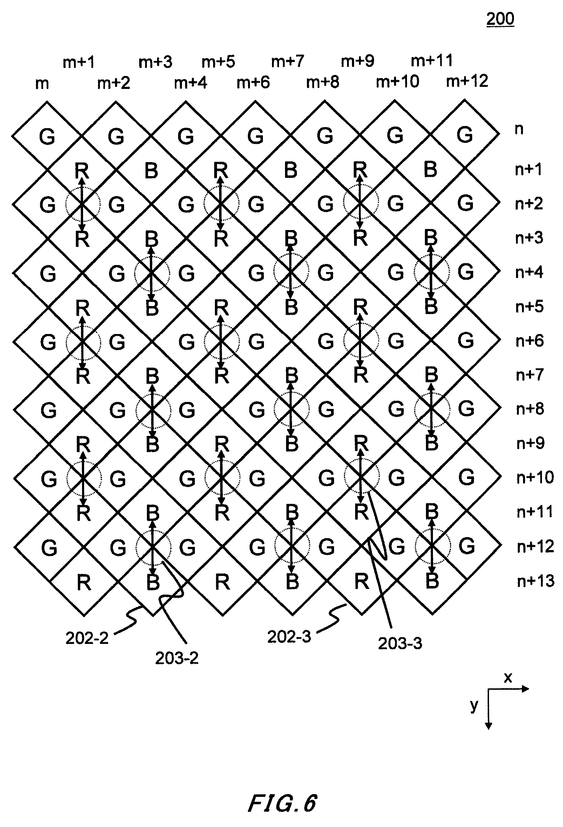

FIG 6 is a figure illustrating one example of an array conversion process in the signal processing unit 210. In FIG. 6, a process of generating conversion pixel signals of second conversion pixels 203-2 and third conversion pixels 203-3 after array conversion from pixel signals of the second pixels 202-2 and the third pixels 202-3 is explained. The second pixels 202-2 and third pixels 202-3 of the present example are arrayed in the columns where k is odd numbers. In the present example, the second pixels 202-2 are arrayed in the columns m+3, m+7, m+11, .... Also, the third pixels 202-3 are arrayed in the columns m+1, m+5, m+9, ....

The signal processing unit 210 adds pixel signals of two second pixels 202-2 adjacent in the column direction to generate a conversion pixel signal of a second conversion pixel 203-2 virtually arranged between the two second pixels 202-2. Also, the signal processing unit 210 adds pixel signals of two third pixels 202-3 adjacent in the column direction to generate a conversion pixel signal of a third conversion pixel 203- 3 virtually arranged between the two third pixels 202-3. In FIG. 6, two pixels 202 whose pixel signals are added are connected with two-way arrows.

It should be noted that pairs of second pixels 202-2 and pairs of third pixels 202-3 whose pixel signals are added are selected such that two-way arrows connecting two first pixels 202-1 explained in FIG. 4, and two-way arrows connecting two second pixels 202-2 and two-way arrows connecting two third pixels 202-3 explained in FIG. 6 do not overlap. That is, pairs of second pixels 202-2 and pairs of third pixels 202-3 whose pixel signals are added are selected such that positions of first conversion pixels 203-1, second conversion pixels 203-2 and third conversion pixels 203-3 do not overlap.

More specifically, the second pixels 202-2 at the row positions (n+3, n+5), (n+7, n+9) and (n+11, n+13) are grouped together. In contrast, the third pixels 202-3 at the column positions (n+1, n+3), (n+5, n+7) and (n+9, n+11) are grouped together.

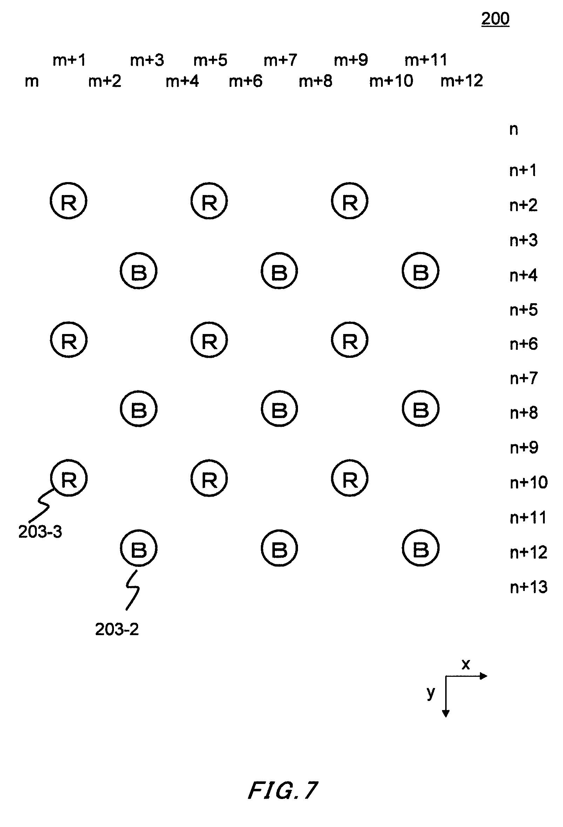

FIG. 7 is a figure illustrating an array example of the second conversion pixels 203-2 and the third conversion pixels 203-3. By the conversion process explained with reference to FIG. 6, the second conversion pixels 203-2 and the third conversion pixels 203-3 are arrayed as shown in FIG. 7. Specifically, in the columns m+3, m+7 and m+11, the second conversion pixels 203-2 are arranged at the row positions n+4, n+8 and n+12. Also, in the rows m+1, m+5 and m+9, the third conversion pixels 203-3 are arranged at the row positions n+2, n+6 and n+10.

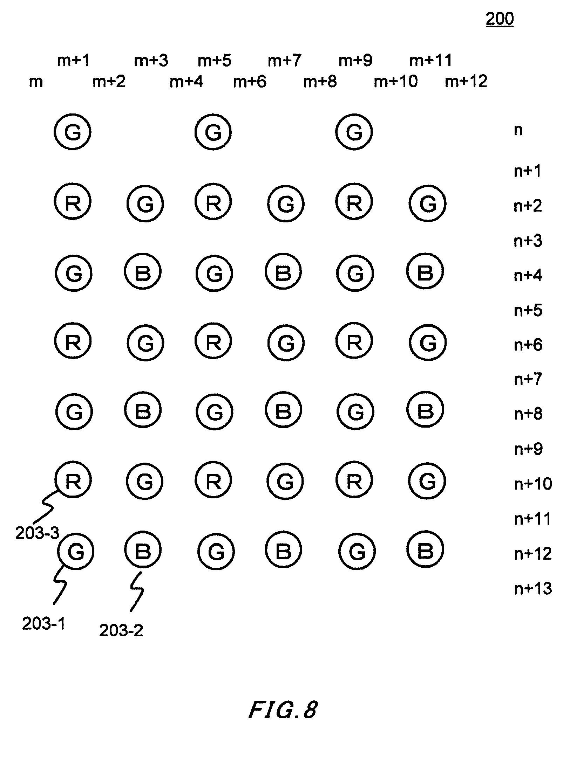

FIG. 8 is a figure illustrating an array example of the first conversion pixels 203-1, the second conversion pixels 203-2 and the third conversion pixels 203-3. The array shown in FIG 8 is an array obtained by superimposing the arrays of the respective conversion pixels 203 shown in FIGs. 5 and 7. By the processes explained with reference to FIGs. 4 to 7, the signal processing unit 210 can acquire image data with a Bayer array as shown in FIG 8.

Because with the imaging element 100 explained above, pixels for image surface phase difference detection can be arranged serially in the row direction and the column direction, the precision of detecting image surface phase differences can be improved. Image data with a Bayer array can be acquired with a simple operation of adding pixel signals of adjacent pixels 202. Also, because light-shielding is not used for image surface phase difference detection, the efficiency of utilizing light can be improved.

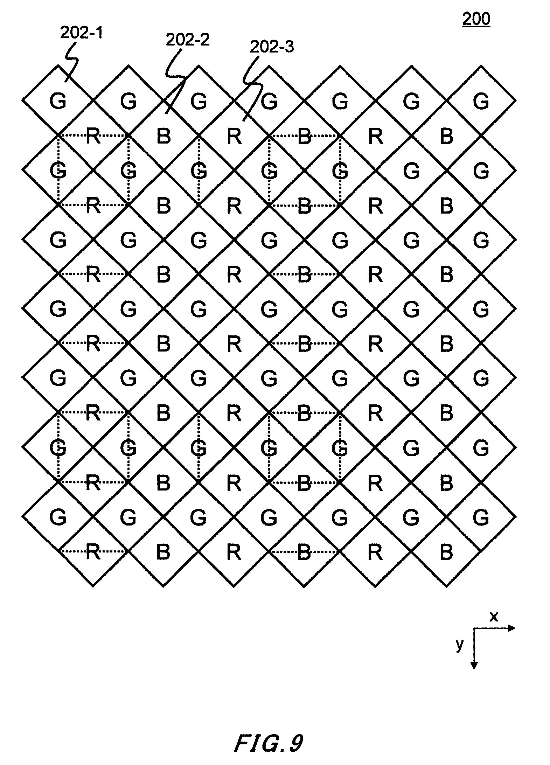

FIG. 9 is a figure illustrating another example of the light-receiving unit 200. In the light-receiving unit 200 of the present example, some first pixels 202-1, some second pixels 202-2 and some third pixels 202-3 respectively have two light-receiving regions 214. The first pixels 202-1 having two light-receiving regions 214 are arranged serially in the row direction. Also, the second pixels 202-2 having two light-receiving regions 214 are arranged serially in the column direction. Also, the third pixels 202-3 having two light-receiving regions 214 are arranged serially in the column direction. In other respects, the configuration is the same as that of the light-receiving unit 200 explained with reference to FIGs. 1 to 8.

Also with the configuration like this, because pixels for image surface phase difference detection can be arranged serially in the column direction and the row direction, the precision of detecting image surface phase differences can be improved. Only by adding pixel signals of adjacent pixels 202, image data with a Bayer array can be acquired. Also, because light-shielding is not used for image surface phase difference detection, the efficiency of utilizing light can be improved.

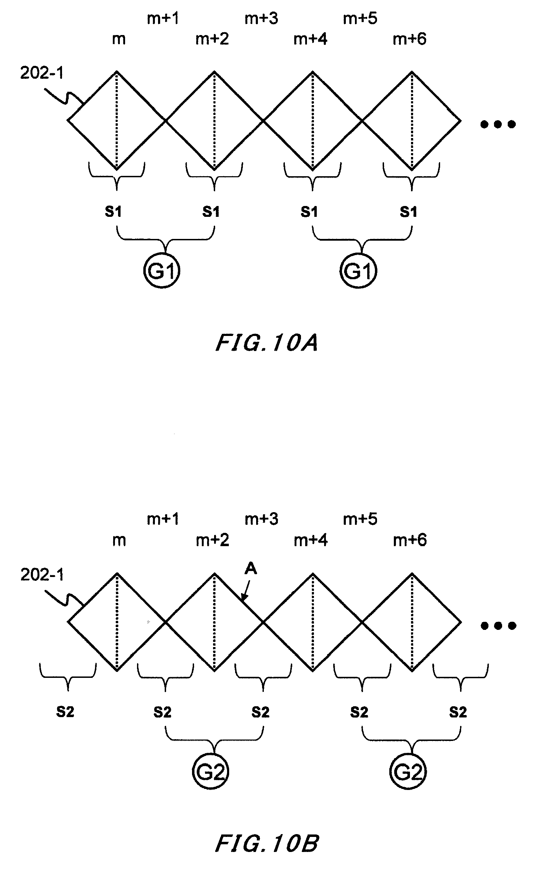

FIGs. 10A to 10D are figures for explaining another process example of the signal processing unit 210. The signal processing unit 210 of the present example generates first to fourth conversion pixel signals whose positions in the row direction are staggered, as conversion pixel signals for the first pixels 202-1. FIG 10A is a figure illustrating an example of generating a first conversion pixel signal G1. The process of the present example is the same as the process explained with reference to FIG. 4. That is, for each of the first pixels 202-1, the signal processing unit 210 adds output signals of the first light-receiving region 214a and the second light-receiving region 214b in the pixel to generate a first pixel signal S1. The signal processing unit 210 adds the first pixel signals S1 of two adjacent first pixels 202-1 to generate the first conversion pixel signal G1. In the present example, the first conversion pixel signals G1 are signals of virtual conversion pixels at the positions m+1, m+5, ....

FIG. 10B is a figure illustrating an example of generating a second conversion pixel signal G2. In the present example, the second conversion pixel signal G2 is a signal of a conversion pixel at a position different from that of the first conversion pixel signal G1. In the present example, for each of the first pixels 202-1, an output signal of a first light-receiving region 214a of the pixel and an output signal of a second light-receiving region 214b of a first pixel 202-1 adjacent to the first light-receiving region of the pixel are added to generate a second pixel signal S2. The signal processing unit 210 adds the adjacent second pixel signals S2 to generate the second conversion pixel signal G2. In the present example, the second conversion pixel signals G2 are signals of virtual conversion pixels at the positions m+2, m+6, ....

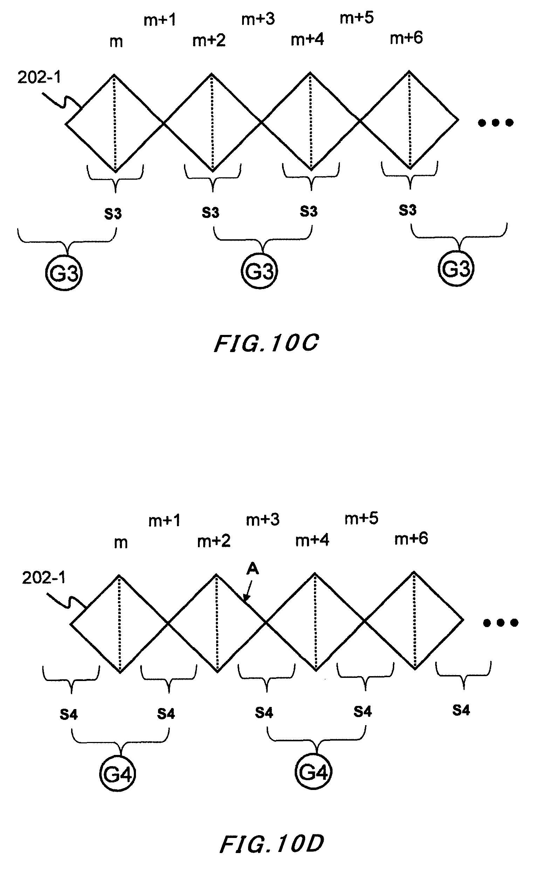

FIG. 10C is a figure illustrating an example of generating a third conversion pixel signal G3. In the present example, the third conversion pixel signal G3 is a signal of a conversion pixel at a position different from that of the first conversion pixel signal G1 and the second conversion pixel signal G2. First, a third pixel signal S3 is generated by the same process as that for the first pixel signal S 1. The signal processing unit 210 adds the adjacent third pixel signals S3 to generate the third conversion pixel signal G3. In the present example, the third conversion pixel signals G3 are signals of virtual conversion pixels at the positions m+3, m+7, ....

FIG. 10D is a figure illustrating an example of generating a fourth conversion pixel signal G4. In the present example, the fourth conversion pixel signal G4 is a signal of a conversion pixel at a position different from that of the first conversion pixel signal G1, the second conversion pixel signal G2 and the third conversion pixel signal G3. First, a fourth pixel signal S4 is generated by the same process as that for the second pixel signal S2. The signal processing unit 210 adds adjacent fourth pixel signals S4 to generate the fourth conversion pixel signal G4. In the present example, the fourth conversion pixel signals G4 are signals of virtual conversion pixels at the positions m, m+4, ....

With a process like this, the signal processing unit 210 can generate multiple types of the conversion pixel signals G1 to G4 whose positions are different. The signal processing unit 210 may use multiple types of conversion pixel signals as image data of one frame or as image data of different frames. That is, an image formed by multiple types of conversion pixel signals may be displayed approximately simultaneously or may be displayed at timing of different frames. Also, the signal processing unit 210 may generate the above-mentioned multiple types of conversion pixel signals from pixel signals captured approximately simultaneously, or generate the multiple types of conversion pixel signals from pixel signals acquired at different capturing timing. With a process like this, spatial resolution of image data can be improved. It should be noted that although with reference to FIGs. 10A to 10D, the first pixels 202-1 were explained as an example, multiple types of conversion pixel signals of the second pixels 202-2 and the third pixels 202-3 can be generated with a similar process.

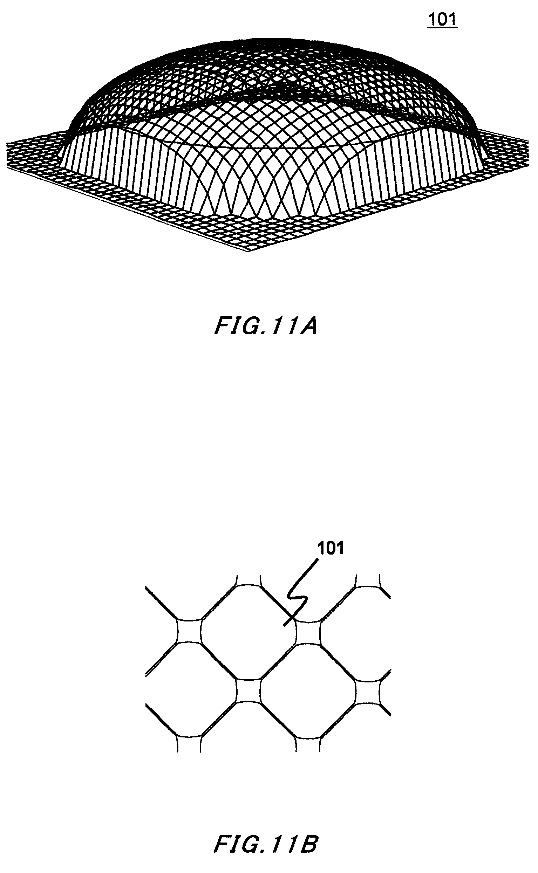

FIGs. 11 A and 11B are figures illustrating a structure example of the microlens 101. FIG. 11 A is a perspective view of the microlens 101. The curved grid lines indicate a curved surface, and the straight grid lines indicate a planar surface.

FIG. 11B is a figure illustrating the planar shape of the microlens 101. As illustrated in FIGs. 11 A and 11B, the microlens 101 has a shape like the one formed by cutting off a spherical lens to form four sides. Thereby, a spherical lens with a large diameter can be used, and an effective aperture of the microlens 101 can be enlarged. Also, matching the positions of the four sides of the microlenses 101 with the positions of the four sides of pixels 202, the microlenses 101 can be spread all over efficiently.

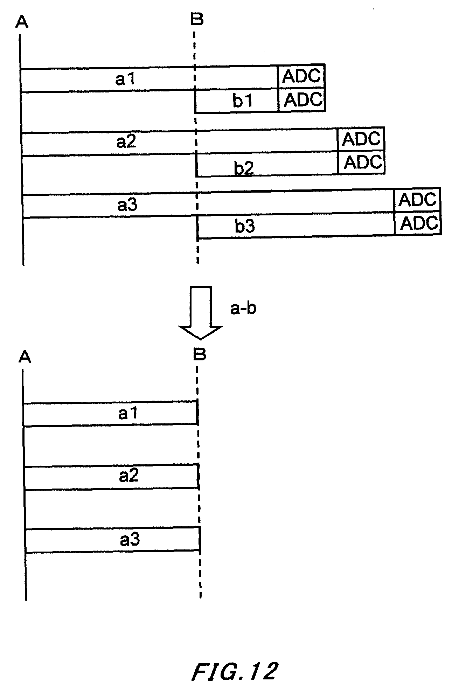

FIG. 12 is a figure illustrating another processing example of the signal processing unit 210. The signal processing unit 210 of the present example selects, row by row, pixels 202 where output signals are to be read out from light-receiving regions 214. The signal processing unit 210 simultaneously reads out output signals of the pixels 202 belonging to a selected row. In this case, timing to read out output signals becomes different row by row, and electrical charge accumulation time become different row by row. The signal processing unit 210 of the present example compensates differences of the electrical charge accumulation time by correcting output signals of the first light-receiving regions 214a by using output signals of the second light-receiving regions 214b of the respective pixels 202. It should be noted that in the light-receiving unit 200 of the present example, all the pixels 202 have two light-receiving regions 214.

In FIG. 12, electrical charge accumulation time of first light-receiving regions 214a and second light-receiving regions 214b of pixels 202 belonging to a first row are denoted with a1 and b1, respectively. Also, electrical charge accumulation time of first light-receiving regions 214a and second light-receiving regions 214b of pixels 202 belonging to a second row are denoted with a2 and b2, respectively. The same applies to other rows. Also, ADC in FIG. 12 indicates time during which digital conversion is performed on output signals of respective light-receiving regions 214.

As shown in FIG 12, for each pixel 202, the signal processing unit 210 delays reset timing B of a second light-receiving region 214b relative to reset timing A to reset electrical charges accumulated in a first light-receiving region 214a. For this reason, the light-receiving unit 200 has a reset line for independently controlling reset timing of the first light-receiving region 214a and the second light-receiving region 214b of each pixel 202. The reset timing A and the reset timing B are common to all the pixels 202.

For each pixel 202, the signal processing unit 210 simultaneously reads out output signals according to the amounts of electrical charges accumulated in the first light-receiving region 214a and the second light-receiving region 214b. For this reason, the light-receiving unit 200 has a readout line for transmitting, in parallel, output signals of the first light-receiving region 214a and the second light-receiving region 214b of each pixel 202. Also, the signal processing unit 210 has a processing circuit for processing, in parallel, output signals of the first light-receiving region 214a and the second light-receiving region 214b of each pixel 202.

For each pixel 202, the signal processing unit 210 subtracts the value of the output signal of the second light-receiving region 214b from the value of the output signal of the first light-receiving region 214a to generate a pixel signal of the pixel 202. Thereby, for all the pixels 202, pixel signals according to electrical charge accumulation time from the reset timing A to the reset timing B can be generated. With a process like this, pixel signals by a global shutter can be generated spuriously from output signals read out by rolling readout. The signal processing unit 210 functions also as a global shutter processing unit that performs the process explained with reference to FIG 12.

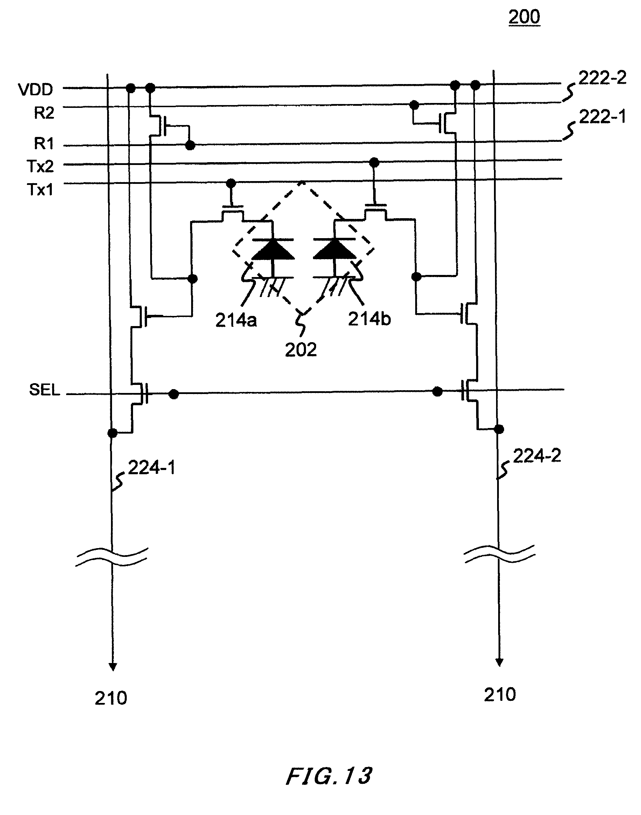

FIG. 13 is a figure illustrating a configuration example of the light-receiving unit 200. Although in FIG. 13, the configuration of a single pixel 202 is illustrated, all the pixels 202 in the light-receiving unit 200 have a similar configuration. As described above, the light-receiving unit 200 has a reset line 221-1 for controlling reset timing of the first light-receiving region 214a, and a reset line 221-2 for controlling reset timing of the second light-receiving region 214b. The reset lines 221-1 and 221-2 are provided to each row of the pixels 202. Pixels 202 included in the same row are connected to the common reset lines 221-1 and 221-2.

Also, the light-receiving unit 200 has a readout line 224-1 for reading out output signals of the first light-receiving regions 214a, and a readout line 224-2 for reading out output signals of the second light-receiving regions 214b. The readout lines 224-1 and 224-2 are provided to each column of the pixels 202. Pixels 202 included in the same column are connected to the common readout lines 224-1 and 224-2. The readout lines 224 transmit respective output signals to the signal processing unit 210.

It should be noted that the signal processing unit 210 selects, by using a row selecting signal SEL, a row from which output signals are read out. Also, the signal processing unit 210 selects, by using transfer signals Tx1, Tx2, a light-receiving region 214 from which output signals are transferred.

With a configuration like this, for each pixel 202, the signal processing unit 210 functions as a readout unit that reads out output signals according to the amounts of electrical charges accumulated in the first light-receiving region 214a and second light-receiving region 214b simultaneously and independently for each light-receiving region. Furthermore, the signal processing unit 210 can spuriously generate pixel signals by a global shutter from output signals read out by rolling readout. It should be noted that the signal processing unit 210 may perform the array conversion process by using pixel signals explained with reference to FIGs. 11 A, 11B and 12, in place of pixel signals explained with reference to FIGs. 1 to 10D. That is, the signal processing unit 210 may generate pixel signals by subtracting an output signal of a second light-receiving region 214b from an output signal of a first light-receiving region 214a without adding output signals of the first light-receiving region 214a and the second light-receiving region 214b.

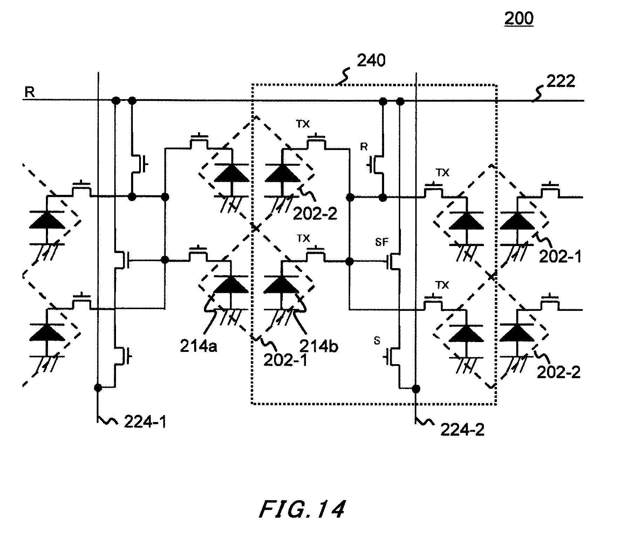

FIG. 14 is a figure illustrating another configuration example of the light-receiving unit 200. In the configuration of the present example, the global shutter process explained with reference to FIGs. 12 and 13 is not performed. In the present example, respective light-receiving regions 214 are photodiodes. In the light-receiving unit 200 of the present example, a reset transistor R, a source follower transistor SF and a selection transistor S that are common to four photodiodes are provided. For example, the reset transistor R and the like that are common to four photodiodes included in a region 240 are provided.

Also, a transfer transistor TX is provided to each photodiode. Also, the four photodiodes are respectively included in different pixels 202. For example, four photodiodes that share a reset transistor R and the like are included in two first pixels 202-1 and two second pixels 202-2.

It should be noted that the transfer transistor TX switches whether or not to transfer electrical charges accumulated in a photodiode to an electrical charge detecting unit. The electrical charge detecting unit is a capacity (not illustrated) connected for example between wiring and reference potential. The electrical charge detecting unit is also shared by four photodiodes.

The reset transistor R switches whether or not to reset electrical charges transferred to the electrical charge detecting unit. The source follower transistor SF outputs an output signal according to electrical charges accumulated in the electrical charge detecting unit. The selection transistor S switches whether or not to output the output signal to the readout line 224.

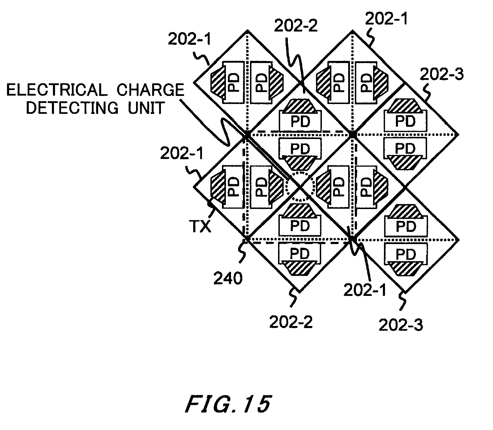

FIG. 15 is a figure illustrating arrangement examples of the transfer transistor TX and of the electrical charge detecting unit in the example illustrated in FIG. 14. In the present example, the pixels 202 and transistors are provided in different layers. For this reason, the pixels 202 and the transistors can be arranged to overlap. As described above, four photodiodes PD share an electrical charge detecting unit, a reset transistor R and the like. The respective photodiodes PD are provided with transfer transistors TX. In FIG. 15, gate electrodes of the transfer transistors TX are indicated by shaded portions.

Four photodiodes are included in two first pixels 202-1 and two second pixels 202-2 or third pixels 202-3. Because first pixels 202-1 are divided in a direction, and a second pixel 202-2 and a third pixel 202-3 are divided in a direction that is different from the direction in which the first pixels 202-1 are divided, a region surrounded by four transfer transistors TX is formed. The region functions as an electrical charge detecting unit. It should be noted that although in FIG. 15, the reset transistor R and the like are omitted, the reset transistor R and the like are also shared by four photodiodes as shown in FIG. 14.

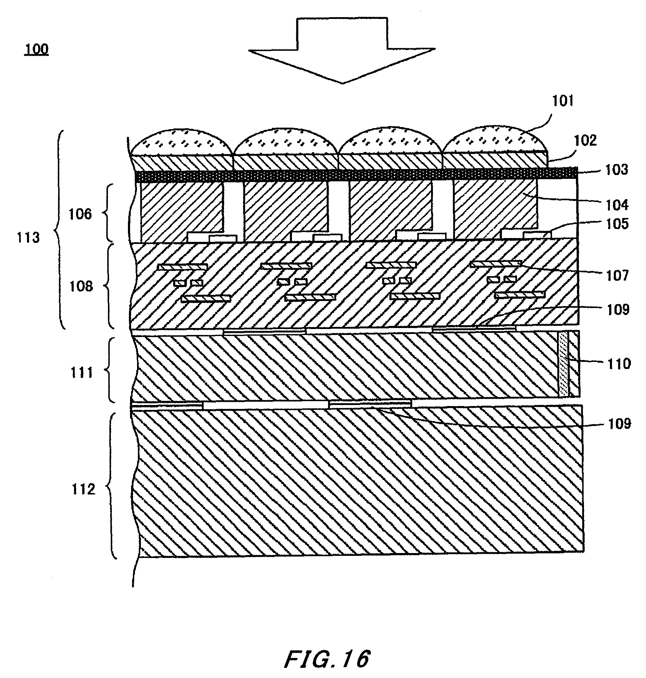

FIG. 16 is a figure illustrating one example of a cross-section of the imaging element 100. Although in the present example, a backside irradiation-type imaging element 100 is illustrated, the imaging element 100 is not limited to the backside irradiation-type. The imaging element 100 of the present example comprises an imaging chip 113 that outputs a signal corresponding to incident light, a signal processing chip 111 that processes the signal from the imaging chip 113, and a memory chip 112 that stores therein image data processed by the signal processing chip 111. These imaging chip 113, signal processing chip 111 and memory chip 112 are stacked, and are electrically connected with each other by electrically conductive bumps 109 such as Cu.

It should be noted that as illustrated, incident light is incident mainly in the direction indicated by an outline arrow. In the present embodiment, the surface of the imaging chip 113 on which the incident light is incident is called a backside. One example of the imaging chip 113 is a backside irradiation-type MOS image sensor. The imaging chip 113 corresponds to the light-receiving unit 200. A PD (photodiode) layer 106 is disposed on the backside of a wiring layer 108. The PD layer 106 is disposed two-dimensionally, and has a plurality of PD units 104 that accumulate electrical charges according to incident light, and transistors 105 provided corresponding to the PD units 104. One PD unit 104 is provided to one pixel 202. That is, the PD unit 104 has a first light-receiving region 214a and a second light-receiving region 214b.

The side of the PD layer 106 on which incident light is incident is provided with a color filter 102 via a passivation film 103. There are multiple types of the color filters 102 that allow passage of light of mutually different wavelength regions, and the color filters 102 are arrayed in specific manners corresponding to the respective PD units 104. A set of the color filter 102, the PD unit 104 and the plurality of transistors 105 form one pixel. By controlling ON and OFF of the plurality of transistors 105, readout timing, light-reception start timing (reset timing) or the like of each light-receiving region 214 is controlled.

The side of the color filter 102 on which incident light is incident is provided with the microlens 101 corresponding to each pixel. The microlens 101 concentrates incident light towards a corresponding PD unit 104.

The wiring layer 108 has wiring 107 that transmits a signal from the PD layer 106 to the signal processing chip 111. The wiring 107 corresponds for example to the readout line 224 illustrated in FIG 12. Also, a gate electrode of each transistor illustrated in FIGs. 13 and 14 may be formed in the wiring layer 108. Also, each transistor illustrated in FIGs. 13 and 14 may be formed in the signal processing chip 111. In this case, the wiring 107 corresponds to wiring that connects the PD layer 106, and each transistor. The wiring 107 may be formed by multiple layers, and may be provided with a passive element and an active element. The signal processing chip 111 of the present example includes the signal processing unit 210.

A plurality of the bumps 109 are disposed on the front surface of the wiring layer 108. The plurality of bumps 109 are aligned with a plurality of the bumps 109 provided on an opposing surface of the signal processing chip 111, and the imaging chip 113 and the signal processing chip 111 are pressurized for example; thereby, the aligned bumps 109 are joined and electrically connected with each other.

Similarly, a plurality of the bumps 109 are disposed on mutually opposing surfaces of the signal processing chip 111 and the memory chip 112. These bumps 109 are aligned with each other, and the signal processing chip 111 and the memory chip 112 are pressurized for example; thereby, the aligned bumps 109 are joined and electrically connected with each other.

It should be noted that the bumps 109 may be joined with each other not only by Cu bump joining by solid phase diffusion, but also by micro bump coupling by solder melting. Also, about one bump 109 may be provided to one unit block described below. Accordingly, the size of the bumps 109 may be larger than the pitch of the PD units 104. Also, in a peripheral region other than an imaging region in which pixels are arrayed, bumps larger than the bumps 109 corresponding to the imaging region may be provided together.

The signal processing chip 111 has a TSV (through-silicon via) 110 connecting, with each other, circuits respectively provided to the front and rear surfaces. The TSV 110 is preferably provided to a peripheral region. Also, the TSV 110 may also be provided to a peripheral region of the imaging chip 113 and the memory chip 112.

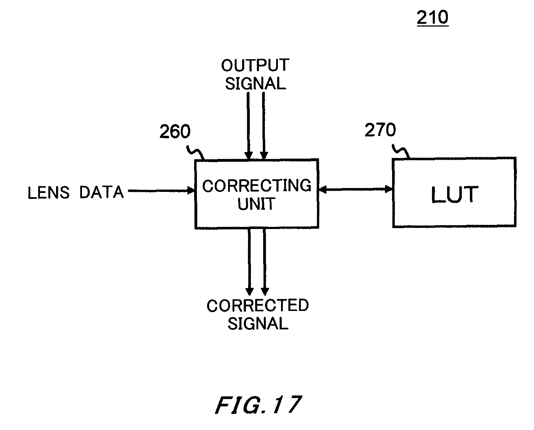

FIG. 17 is a block diagram illustrating a some of functions of the signal processing unit 210. The signal processing unit 210 of the present example has a correcting unit 260 and a look-up table 270. As explained with reference to FIGs. 1 to 16, the signal processing unit 210 adds or subtracts output signals of two light-receiving regions 214 in each pixel 202. However, output signals of two light-receiving regions 214 may fluctuate depending on characteristics of a lens through which a light incident on an imaging element has passed.

For example, the ratio of output values of a first light-receiving region 214a and a second light-receiving region 214b in each pixel 202 fluctuates depending on the EPD value and the F number of a lens. The EPD value is a value indicating a distance from an image surface (the front surface of the imaging element 100) to an exit pupil of a lens. Also, the F number is a value obtained by dividing a focal distance of a lens with an effective aperture. The look-up table 270 stores therein a table in which correction values for correcting output values of respective light-receiving regions 214 are associated with characteristic values of a lens such as the EPD value and the F number. The characteristic values of a lens and the table of correction values may be set for respective positions of the pixels 202.

The correcting unit 260 receives, from an imaging device, lens data of a lens which a light incident on an imaging element has passed, and receives an output signal from the light-receiving unit 200. For example, the imaging device may detect lens characteristics from identification information of a lens unit being used. Also, the imaging device may detect lens characteristics based on operation of the imaging device by a user or the like. Also, the correcting unit 260 further receives information indicating the position of a pixel 202 of the output signal. The positional information may be generated by the signal processing unit 210 based on the row selecting signal SEL or the like.

The correcting unit 260 extracts, from the look-up table 270, a correction value corresponding to the lens data. The correction value may be different for each light-receiving region 214. The correcting unit 260 generates corrected signals obtained by correcting output signals of the two light-receiving regions 214 by using the extracted correction value
The signal processing unit 210 generates pixel signals by using the corrected signals.

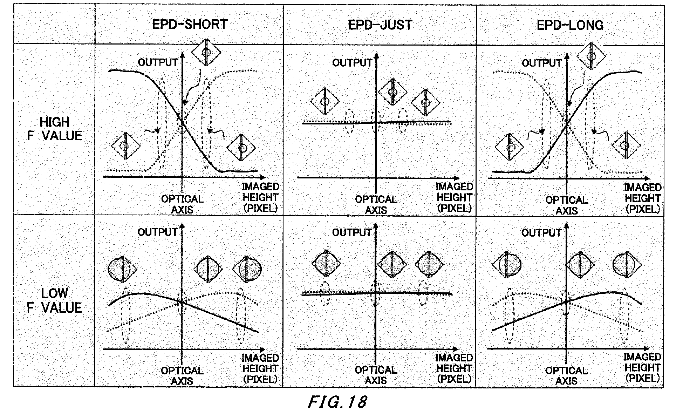

FIG 18 is a figure for explaining a relationship between lens characteristics and output signals. In FIG. 18, the horizontal axis indicates the distance of a pixel 202 relative to an optical axis, and the vertical axis indicates the intensity of an output signal of a light-receiving region 214 in each pixel 202. In FIG 18, output signals of two light-receiving regions 214 are indicated with a solid line and a dotted line.

Normally, the microlenses 101 in the imaging element 100 are arranged by being shifted relative to pixels 202 depending on the positions of the pixels 202 relative to the optical axis. By designing in this manner, with a lens having a particular EPD value, the spot of light is arranged at the center of a pixel 202 at any position. In this manner, the EPD value that allows the spot of light to be at the center of a pixel 202 at any position is called "EPD-just".

In contrast, with a lens whose EPD becomes smaller or a lens whose EPD becomes larger than an EPD-just lens, the spot of light deviates from the center of a pixel 202 depending on the position of the pixel 202. Because the pixels 202 are divided into two light-receiving regions 214 by center lines, if the spot of light deviates from the centers of the pixels 202, a large difference is generated in the intensity of output signals between the two light-receiving regions 214. For example, at a position that is far from the optical axis, most of the spot of light is included in one light-receiving region 214, and the intensity of an output signal of the light-receiving region 214 becomes very large, and in contrast, the intensity of an output signal of the other light-receiving region 214 becomes very small.

Also, if the F number fluctuates, the spot diameter of light on an image surface changes. For example, if the F number is small, the spot diameter becomes large. In this case, the difference between the intensity of output signals of two light-receiving regions 214 becomes small. On the other hand, at a position that is far from the optical axis, the spot of light goes out of the region of a pixel 202, and the intensity of output signals of the pixel 202 as a whole decreases.

In this manner, the intensity of output signals of two light-receiving regions 214 fluctuates depending on lens characteristics such as the EPD value or the F number. A table in which correction values for correcting the fluctuation and lens characteristic values are associated is provided to the signal processing unit 210 of the present example. The table can be created by changing lens characteristics and actually detecting output signals. With a configuration like this, pixel signals can be generated more precisely.

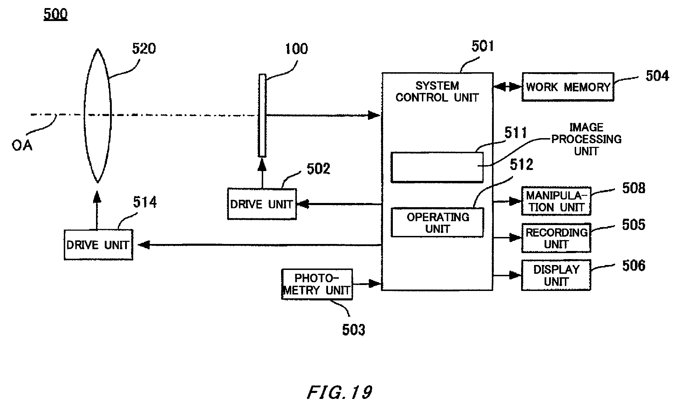

FIG. 19 is a block diagram illustrating a configuration example of an imaging device 500 according to one embodiment. The imaging device 500 comprises an imaging lens 520 as an image-capturing optical system, and the imaging lens 520 guides a subject light flux that is incident along an optical axis OA to the imaging element 100. The imaging lens 520 may be a replaceable lens that can be attached to and detached from the imaging device 500. The imaging device 500 mainly comprises the imaging element 100, a system control unit 501, a drive unit 502, a photometry unit 503, a work memory 504, a recording unit 505, a display unit 506 and a drive unit 514.

The imaging lens 520 is configured with a plurality of groups of optical lenses, and forms, near its focal plane, an image of a subject light flux from a scene. It should be noted that in FIG 19, the imaging lens 520 is expressed by a single virtual representative lens arranged near the pupil.

The drive unit 514 drives the imaging lens 520. More specifically, the drive unit 514 moves the optical lens group of the imaging lens 520 to alter the focus position, and drives iris diaphragm in the imaging lens 520 to control the light amount of a subject light flux incident on the imaging element 100.

The drive unit 502 is a control circuit that performs electrical charge accumulation control such as timing control, region control or the like of the imaging element 100 according to an instruction from the system control unit 501. The drive unit 502 causes the light-receiving unit 200 and the signal processing unit 210 of the imaging element 100 to operate as explained with reference to FIGs. 1 to 18. Also, a manipulation unit 508 receives an instruction from an image-capturing person through a release button or the like.

The imaging element 100 is the same as the imaging element 100 explained with reference to FIGs. 1 to 18. The imaging element 100 passes a pixel signal to the image processing unit 511 of the system control unit 501. The image processing unit 511 performs various image processing by using the work memory 504 as a work space, and generates image data. For example, when generating image data of the JPEG file format, a color moving image signal is generated from a signal obtained in a Bayer array, and thereafter, compression is performed. The image processing unit 511 may have the signal processing unit 210. In this case, the imaging element 100 may not have the signal processing unit 210. Generated image data is recorded in the recording unit 505, and is converted into a display signal to be displayed on the display unit 506 for preset length of time.

The photometry unit 503 detects the luminance distribution of a scene prior to a series of image-capturing sequences to generate image data. The photometry unit 503 includes an AE sensor of about one million pixels, for example. The operating unit 512 of the system control unit 501 receives an output of the photometry unit 503 to calculate the luminance of each region of a scene. The operating unit 512 determines the shutter speed, diaphragm value, ISO speed according to the calculated luminance distribution. The imaging element 100 may double as the photometry unit 503. It should be noted that the operating unit 512 performs various types of operations for causing the imaging device 500 to operate. The drive unit 502 may be partially or entirely mounted on the signal processing chip 111 of the imaging element 100. The system control unit 501 may be partially mounted on the signal processing chip 111 of the imaging element 100.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### [Explanation of Reference Symbols]

- 100:: imaging element
- 101:: microlens
- 102:: color filter
- 103:: passivation film
- 104:: PD unit
- 105:: transistor
- 106:: PD layer
- 107:: wiring
- 108:: wiring layer
- 109:: bump
- 110:: TSV
- 111:: signal processing chip
- 112:: memory chip
- 113:: imaging chip
- 200:: light-receiving unit
- 202:: pixel
- 203:: conversion pixel
- 210:: signal processing unit
- 214:: light-receiving region
- 214a:: first light-receiving region
- 214b:: second light-receiving region
- 222-1, 222-2:: reset line
- 224:: readout line
- 260:: correcting unit
- 270:: look-up table
- 500:: imaging device
- 501:: system control unit
- 502:: drive unit
- 503:: photometry unit
- 504:: work memory
- 505:: recording unit
- 506:: display unit
- 508:: manipulation unit
- 511:: image processing unit
- 512:: operating unit
- 514:: drive unit
- 520:: imaging lens

## Claims

1. An imaging element comprising:
two first pixels that are arranged serially in a first direction and detect light of a first color;
two second pixels that are arranged serially in a second direction intersecting the first direction, are adjacent to the two first pixels, and detect light of a second color;
a plurality of first light-receiving regions that are arranged in the first pixels, receive light of the first color, and are divided in the first direction; and
a plurality of second light-receiving regions that are arranged in the second pixels, receive light of the second color, and are divided in the second direction.

2. The imaging element according to Claim 1, wherein the first direction and the second direction are orthogonal to each other.

3. The imaging element according to Claim 1 or 2, further comprising a focus detecting unit that detects a focused state based on an output signal from the first pixels and an output signal from the second pixels.

4. The imaging element according to any one of Claims 1 to 3, comprising:
an imaging unit in which the first pixels and the second pixels are arranged; and
a signal processing unit that is stacked on the imaging unit, and processes a signal from the imaging unit.

5. The imaging element according to any one of Claims 1 to 4, comprising a plurality of the first pixels, and comprising:
two third pixels that are arranged serially in a third direction intersecting the first direction, are adjacent to two first pixels among the plurality of first pixels, and detect light of a third color; and
a plurality of third light-receiving regions that are arranged in the third pixel, are divided in the third direction, and receive light of the third color.

6. The imaging element according to Claim 5, wherein the second direction and the third direction are parallel.

7. An imaging element comprising:
a plurality of first pixels that are arrayed along a first direction and a second direction, and correspond to a first color; and
a plurality of other pixels that are provided in respective regions surrounded by four contiguous first pixels, and correspond to a color different from the first color, wherein
among the plurality of first pixels and the plurality of other pixels, at least some pixels have two separate light-receiving regions.

8. The imaging element according to Claim 7, further comprising a focus detecting unit that detects a focused state of the imaging element based on an output signal from each light-receiving region of a pixel having the two light-receiving regions.

9. The imaging element according to Claim 7 or 8, wherein
the plurality of other pixels include:
a plurality of second pixels that are arrayed along the second direction, and correspond to a second color; and
a plurality of third pixels that are arrayed along the second direction, and correspond to a third color, and
a second pixel column and a third pixel column are arranged alternately in the first direction,
the imaging element further comprising an array converting unit that: adds pixel signals of two of the first pixels adjacent in the first direction to generate a first conversion pixel signal; adds pixel signals of two of the second pixels adjacent in the second direction to generate a second conversion pixel signal; and adds pixel signals of two of the third pixels adjacent in the second direction to generate a third conversion pixel signal.

10. The imaging element according to Claim 9, wherein
at least some pixels of the first pixels have a first light-receiving region and a second light-receiving region arrayed side by side in the first direction, and
at least some pixels of the second pixels and the third pixels have a first light-receiving region and a second light-receiving region that are arrayed side by side in the second direction.

11. The imaging element according to Claim 10, wherein all the pixels have the two light-receiving regions.

12. The imaging element according to Claim 11, wherein for each of the pixels, the array converting unit:
generates a first pixel signal obtained by adding output signals of the first light-receiving region and the second light-receiving region of the pixel; and
generates a second pixel signal obtained by adding an output signal of the first light-receiving region of the pixel, and an output signal of the second light-receiving region of a pixel adjacent to the first light-receiving region of the pixel.

13. The imaging element according to any one of Claims 7 to 12, further comprising a global shutter processing unit that: for each pixel, among the two light-receiving regions, relative to reset timing to reset electrical charges accumulated in a first light-receiving region, delays reset timing of a second light-receiving region; reads out simultaneously output signals according to amounts of electrical charges accumulated in the first light-receiving region and the second light-receiving region; and generates a pixel signal of the pixel by subtracting a value of the output signal of the second light-receiving region from a value of the output signal of the first light-receiving region.

14. The imaging element according to any one of Claims 7 to 12, further comprising a readout unit that, for each pixel, reads out output signals according to amounts of electrical charges accumulated respectively in the two light-receiving regions simultaneously and independently for each light-receiving region.

15. The imaging element according to any one of Claims 7 to 14, wherein
a planar shape of each of the pixels is quadrangle, and
each side of the pixels is inclined by 45 degrees relative to the first direction and the second direction.

16. The imaging element according to any one of Claims 7 to 15, further comprising a correcting unit that corrects values of output signals output respectively by the two light-receiving regions based on lens data indicating a characteristic of a lens through which light incident on the imaging element has passed.

17. The imaging element according to any one of Claims 7 to 16, having:
an imaging chip in which each of the pixels is formed; and
a signal processing chip that is stacked on the imaging chip, and processes a signal from the imaging chip.

18. An imaging device comprising the imaging element according to any one of Claims 1 to 17.
